# EUROPEAN PATENT APPLICATION

(11) **EP 2 031 516 A2**
(43) Date of publication of application: **04.03.2009**
(21) Application number: 08015337.2
(22) Date of filing: 29.09.2008
(51) Int. Cl.: G06F 13/38

(54) **A daisy chain arrangement of non-volatile memories**

(30) Priority: 28.03.2006 US 787710 P; 31.07.2006 US 496278; 23.08.2006 US 839534 P; 14.12.2006 US 639375
(62) Divisional of application: 07719422.3
(71) Applicant: MOSAID Technologies Inc., Kanata, Ontario K2K 2X1 (CA)
(72) Inventor: Kim, Jin-Ki, Kanata, Ontario K2K 3H6 (CA)
(74) Representative: Manke, Lars

(57) **Abstract**

A Flash memory system is implemented in a system-in-package (SIP) enclosure, the system comprising a Flash memory controller and a plurality Flash memory devices. A SIP relates to a single package or module comprising a number of integrated circuits (chips). The Flash memory controller is configured to interface with an external system and a plurality of memory devices within the SIP. The memory devices are configured in a daisy chain cascade arrangement, controlled by the Flash memory controller through commands transmitted through the daisy chain cascade.

## Description

### BACKGROUND OF THE INVENTION

Flash memory is a key enabling technology for consumer applications and mobile storage applications such as flash cards, digital audio & video players, cell phones, USB flash drivers and solid state disks for HDD replacement. As the demand increases for higher density of storage, Flash memory solutions continue to evolve, providing higher density and lower cost of production.

Two popular Flash memory solutions are NOR Flash and NAND Flash. NOR Flash typically has longer erase and write times, but has a full address and data interface that allows random access to any location. The memory cells can be nearly double the size of comparable NAND Flash cells. NOR Flash is most suitable for applications that require random accessibility for code storage. In contrast, NAND Flash typically has faster erase and write times, higher density, and lower cost per bit than NOR Flash; yet its I/O interface allows only sequential access to data, which is suitable for data storage applications such as music files and picture files.

Because many applications require fast, random accessibility to data, products have been developed to combine the advantages of both NOR and NAND Flash memories. One such solution is a NAND Flash memory having an embedded Flash controller on a single integrated circuit (IC). This device employs a NAND Flash array to store data at a high speed with reduced cost and size. Further, control logic accesses and writes to the Flash array in response to external commands, providing an interface with greater accessibility to data, comparable to the interface of a conventional NOR Flash device. Thus, a NAND Flash memory having an embedded Flash controller combines the speed and efficiency of NAND Flash with the accessibility of NOR Flash.

### SUMMARY OF THE INVENTION

A Flash memory device having an embedded memory controller presents a number of disadvantages. In such a device, several components are combined on a single silicon die. Typically the memory capacity in a single die is determined by the process technology, particularly the minimum feature size. In order to increase memory capacity using the same process technology, MCPs (Multi-Chip-Packages) are often deployed. For example, two or four chips may be integrated in a same package to increase memory capacity.

An embedded controller used to control access to a memory array contained in a chip typically increases the chip size from 15% to 30%. If multiple devices are integrated in a package to increase memory capacity, the size overhead associated with memory controller circuitry may become significant because controller circuitry is repeated on each of the multiple devices. Further, wafer yield (the number of working chips produced on a wafer) tends to be a function of chip size. The additional space required by one or more embedded controllers increases chip size, and thus may lead to a drop in overall wafer yield.

The increased complexity of a Flash memory with embedded controller can also have detrimental effects on product diversification, development time and cost, and device performance. Such a device, in contrast to a discrete Flash memory, requires a more complex circuit layout, leading to longer development cycles. Further, product redesign is also hindered because modifications to the design must be adapted to the entire chip. Performance may also be degraded by this design. For example, typical Flash memory requires high voltage transistors to accommodate program and erase operations. A memory controller benefits from utilizing high-speed transistors; however, implementing both high-voltage and high-speed transistors on a single die can significantly increase manufacturing cost. Thus, an embedded controller may instead utilize the high-voltage transistors required by the Flash memory, thereby slowing the performance of the controller.

Embodiments of the present invention provide a memory system that overcomes some of the disadvantages associated with embedded Flash memories and other devices. The memory system comprises a plurality of nonvolatile memory devices in a daisy chain cascade arrangement, controlled by a memory controller device through commands sent through the daisy chain cascade. The memory controller device interfaces with an external system and controls read, write and other operations of the memory devices by communications through the daisy chain cascade arrangement. In such a configuration, communications are received by a first memory device and passed, with any responsive communication, to a second memory device. The process is repeated for all memory devices in the daisy chain cascade, thereby enabling the memory controller to control the memory devices in the daisy chain cascade.

Further embodiments of the memory system may be implemented in a common support assembly such as a system-in-package (SIP) enclosure housing memory controller and memory devices. An SIP is a single package or module comprising a number of integrated circuits (chips). In embodiments described herein, a Flash memory controller within the SIP is configured to interface with an external system and a plurality of memory devices within the SIP. Alternatively, the memory system may be implemented in other single form-factor devices, such as a circuit board.

Further embodiments of the invention include a unidirectional daisy chain cascade through which commands and memory data are sent from the controller in a single direction through the chain of memory devices, returning to the controller from the last device in the daisy chain cascade. The unidirectional cascade includes a first signal path to carry signals relating to the control operations, and a second signal path to carry signals generated by the plurality of nonvolatile memory devices responsive to the control operations. A bidirectional daisy chain cascade may be implemented, where commands and memory data are sent in a single direction through the memory devices, returning to the controller in a converse direction through the devices. The bidirectional daisy chain cascade may further comprise links that are configured to carry signals in two directions through the cascade. The commands may be sent through the daisy chain cascade in serial mode, accompanied by an address field that identifies a particular memory device. Command, data and address signals may be carried by a common signal path in a serial configuration.

Embodiments of the present invention may be implemented as a Flash memory system, where the memory devices include Flash memory. The memory controller may perform Flash control operations, such as erasing a block of Flash memory, programming to a page, and reading a page. The memory controller may comprise control logic to provide mapping of logical addresses to physical addresses at each of the memory devices. The provided mapping may also include operations to provide wear leveling at the memory devices. The memory controller may also communicate with an external system through a NOR or other interface, and control the plurality of NAND memory devices through a nonvolatile memory interface. The memory controller device may also include a memory array, thereby operating as a master Flash memory.

Commands and data sent through the daisy chain cascade may be accompanied by an address corresponding to one of the plurality of memory devices. Each of the devices identifies the commands by comparing the address to a device ID established at that devices. Prior to receiving the commands, the memory devices may generate device IDs in response to associated signals sent through the daisy chain cascade.

### BRIEF DESCRIPTION OF THE DRAWINGS

The foregoing will be apparent from the following more particular description of example embodiments of the invention, as illustrated in the accompanying drawings in which like reference characters refer to the same parts throughout the different views. The drawings are not necessarily to scale, emphasis instead being placed upon illustrating embodiments of the present invention.
FIG. 1 is a block diagram of a prior art memory device with an embedded Flash controller.
FIG. 2 is a block diagram of a memory system in a system-in-package (SIP) enclosure with a plurality of memory devices configured in a unidirectional daisy chain cascade.
FIG. 3 is a block diagram of a memory system in a system-in-package (SIP) enclosure with a plurality of memory devices configured in a bi-directional daisy chain cascade.
FIG. 4A is a block diagram of a Flash memory controller.
FIG. 4B is a block diagram of a Flash memory controller with CPU.
FIG. 5 is a block diagram of an SIP including a master flash memory and a plurality of memory devices in a unidirectional daisy chain cascade configuration.
FIG. 6 is a block diagram of an SIP including a master flash memory and a plurality of memory devices in a bi-directional daisy chain cascade configuration.
FIG. 7 is a block diagram of a memory system as implemented in an SIP layout.
FIG. 8 is a block diagram of a memory system in an SIP enclosure with a plurality of memory devices configured in a unidirectional daisy chain cascade comprising multiple connections.
FIG. 9 is a block diagram of a memory system in an SIP enclosure with a plurality of memory devices configured in a bidirectional daisy chain cascade sharing common ports.

### DETAILED DESCRIPTION OF THE INVENTION

A description of example embodiments of the invention follows.

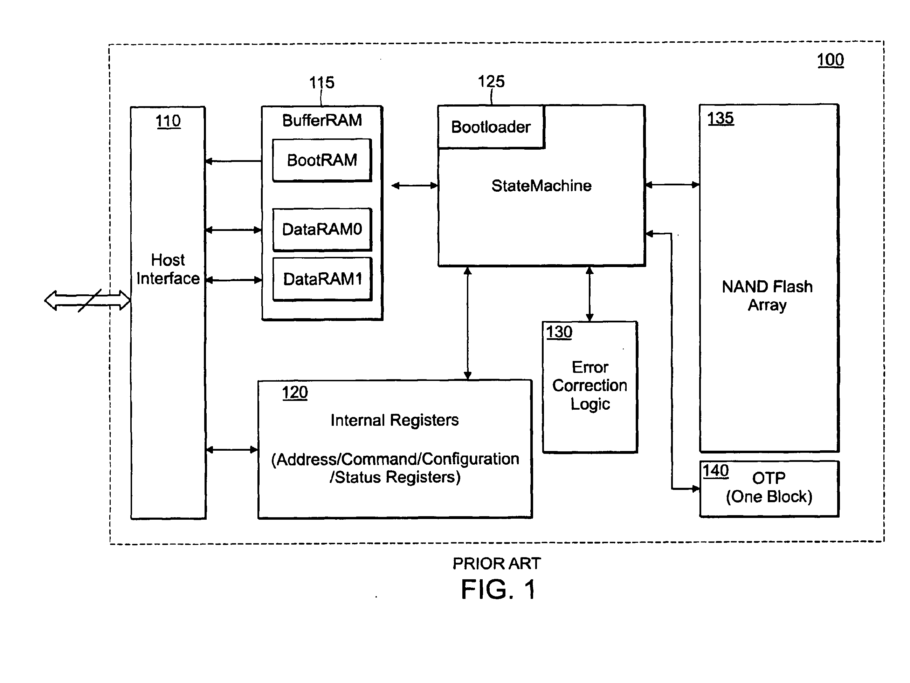

Fig. 1 illustrates an integrated Flash device 100 having a Flash memory 135 and control logic embedded in a single integrated circuit. The control logic includes a host interface 110 for communication with an external system, a memory buffer 115, a state machine 125 for interfacing with the memory 135, internal registers 120 and error correction logic 130. For example, during a read operation, the internal registers 120 receive commands and address data from the host interface 110. The state machine 125 receives this data and accesses the Flash memory 135 in accordance with the read operation. The state machine 125 receives sequential data from the Flash memory 135, from which it retrieves the requested data. After verification by error correction logic 130, the requested data is sent to memory buffer 115 for transmittal to the external system. Further details on the operation of a Flash memory device with an embedded controller may be found in "OneNAND™ Specification," Version 1.2, published by Samsung Electronics Company, December 23, 2005.

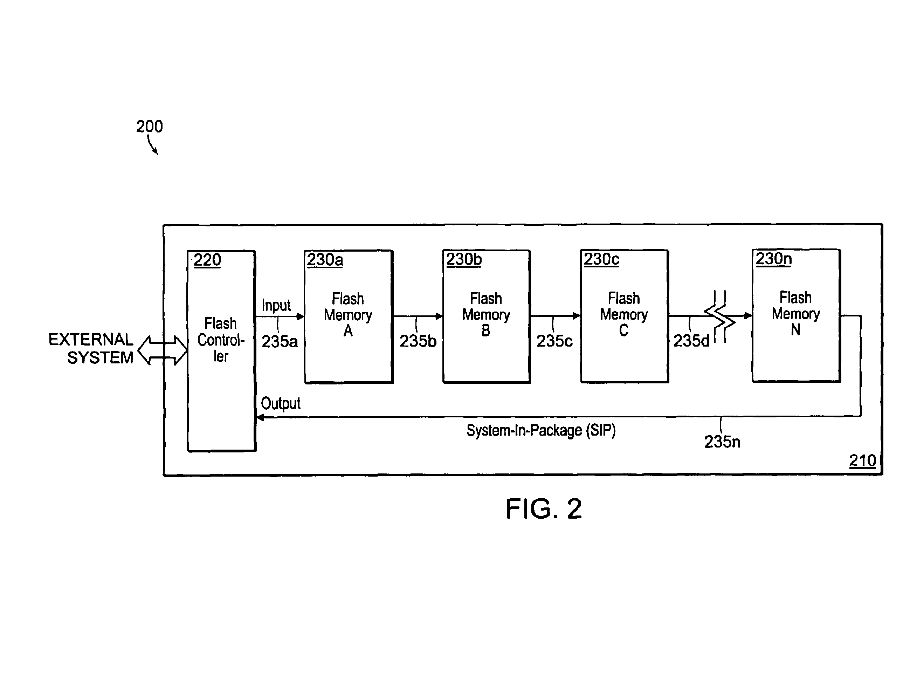

Fig. 2 is a block diagram illustrating a memory system 200 in a system-in-package (SIP) enclosure 210 with a plurality of memory devices 230a-n configured in a daisy chain cascade arrangement. An SIP is a single package or module comprising a number of integrated circuits (chips). The SIP may be designed to operate as an independent system or system component, performing many or all of the functions of an electronic system such as a mobile phone, personal computer, or a digital music player. The chips may be stacked vertically or placed horizontally alongside one another inside the package or module. The chips are typically connected by wires that are encased in the package. Alternatively, the chips may be connected using solder bumps to join them together in a "flip-chip" technology.

An SIP may comprise several circuit components and passive components mounted on the same substrate. For example, an SIP can include a processor implemented in an application-specific integrated circuit (ASIC), a memory implemented in a separate circuit die, and resistors and capacitors associated with the circuitry. Such a combination of components enables a complete functional unit to be built in a single package, obviating the need to add many external components to create a functioning system. A design employing SIP devices is particularly valuable in space-constrained environments such as laptop computers, MP3 players and mobile phones as it reduces the complexity of the system external to the SIP.

The Flash memory system 200 illustrated in Fig. 2 is implemented in an SIP enclosure 210 and includes a Flash memory controller 220 and a plurality of Flash memory devices 230a-n. In accordance with the SIP architecture, the Flash memory controller 220 and Flash memory devices 230a-n are implemented in discrete circuit die (chips) and connected according to the design by, for example, wiring encased in the package or by flip-chip junctions. The Flash controller 220 communicates with an external system (not shown), such as a computer system, through a system interface. The system interface provides a plurality of signal paths between the Flash controller 220 and an external system, the signal paths sending and receiving memory data, commands, clock signals and other signals associated with controlling the memory system 200.

In response to communication with an external system or other instructions, the Flash controller 220 may communicate with one or more of the Flash memory devices 230a-n arranged in a unidirectional daisy chain cascade. In a unidirectional daisy chain cascade configuration, each device in the daisy chain cascade transfers received signals, along with generated signals, to a successive device, thereby providing a single communications path 235 through the devices. The signal path 235 comprises multiple links 235a-n between the devices, and thus represents a single, unidirectional flow of communication from the Flash controller 220 and through the Flash memory devices 230a-n in the daisy chain cascade, returning to the Flash controller 220. Alternatively, the links 235a-n may be bidirectional, connecting to driver and receiver circuitry at the respective devices.

In this example, the Flash controller 220 sends command and data signals through signal path 235a to the first Flash memory device 230a ("Flash memory A") in the daisy chain cascade. Flash memory 230a responds according to the received commands, which may include retrieving stored data, writing data, or performing another operation. Flash memory 230a then outputs any data associated with the response, accompanied by the received commands, to the next memory device 230b. Conversely, if the received commands are not addressed to Flash memory 230a, the device 230a outputs the received commands without performing further operations. Flash memory 230a can determine whether the commands are addressed to it by comparing an address field associated with the command to a device identifier stored at the memory 230a.

Flash memory 230b receives the commands from memory 230a, accompanied by any data generated by the memory 230a. As with the previous memory 230a, Flash memory 230b responds to any commands addressed to it, and outputs the commands and any generated data to the next device 230c. This succession of communication is repeated for all the devices in the signal path 235 until the commands are received by the last Flash memory 230n. Flash memory 230n responds according to the commands and outputs the commands, accompanied by any data generated by the memory devices 230a-n, to the Flash controller 220 through signal path 235n. As a result, communications of the memory system 200 are transferred to all devices in a daisy chain cascade through the signal path 235. The signal path 235 may comprise one or more pin or wire connections between the devices, and may carry signals in serial or parallel. Refer to U.S. Patent Application No. 11/324,023 ("Multiple Independent Serial Link Memory"), U.S. Patent Application No. 11/495,278 ("Daisy Chain Cascading Devices"), U.S. Patent Application No. 11/521,734 (Asynchronous ID Generation") and U.S. Provisional Application No. 60/802,645 ("Serial Interconnection of Memory Devices") for exemplary techniques regarding serial communication of memory devices and daisy chain cascade configurations. The entire teachings of the above applications are hereby incorporated by reference as though fully set forth herein.

In this example, the memory system 200 comprises a plurality of Flash memory devices 230a-n configured in such a manner that input signals from the Flash controller 220 are transferred to the first Flash device and output signals from the last device 230n are transferred to the Flash controller 220. In exemplary embodiments, all signals (including input data and commands from the Flash controller 220) stream down from the first memory device 230a to the last memory device 230n. Thus, all input and output signals are unidirectional, carried on the signal path 235. Input commands may include the address of a target device such as one of the memory devices 230a-n. During system initialization or power-up, the unique device address for each Flash device 230a-n may be assigned by either the Flash controller 220 or the Flash device 230a-n itself, or may have been previously assigned via hardware programming such as a one-time-programmable (OTP) array. When the Flash controller 220 issues a command accompanied by the target device address, the corresponding Flash device (one of the devices 230a-n) performs the received command. The remainder of the Flash devices 230a-n operate in a "bypass" mode with respect to the received command, passing the command to a successive device in the daisy chain cascade arrangement without further operation.

Target device addresses may be established at each of the memory devices 230a-n by an identifier (ID) generation process. U.S. Patent Application No. 11/521,734 (Asynchronous ID Generation"), incorporated by reference in its entirety, includes exemplary techniques for generating IDs at a plurality of memory devices in a daisy chain cascade arrangement. In one exemplary embodiment, each device 230a-n in the daisy chain cascade has a generating circuit (not shown). When the controller 220 transmits a "generate ID" command to the devices 230a-n, the generating circuit at the first device 230a receives a first value from the controller 220, generating a device ID from this value. The device ID may be stored to a register at the first device 230a, and is used to determine whether commands and data are addressed to the device 230a. This generating circuit also produces a second value that is incrementally modified from the first value, which the first device 230a passes to the successive device 230b. The generating circuit at the second device 230b generated a device ID from the second value, and transmits a modified value to the third device 230c. This process is repeated until the last device 230n in the daisy chain cascade establishes a device ID.

Alternatively, the Flash devices 230a-n could be addressed with a device select signal (not shown) through a signal path connecting each device 230a-n and the Flash memory controller 220. In such an embodiment, the Flash memory controller 220 may send a device select signal to the Flash device 220a to which a command is addressed, thereby enabling the device 220a to respond to and perform the received command. The remaining Flash devices 220b-n may not receive a device select signal, and therefore pass the received command to a successive device in the daisy chain cascade arrangement without further operation.

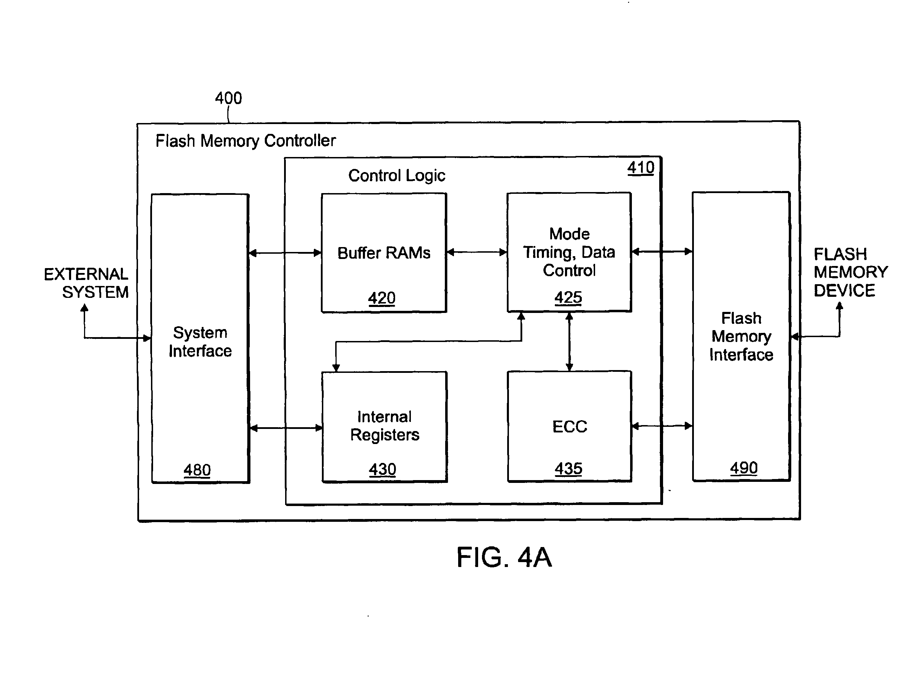

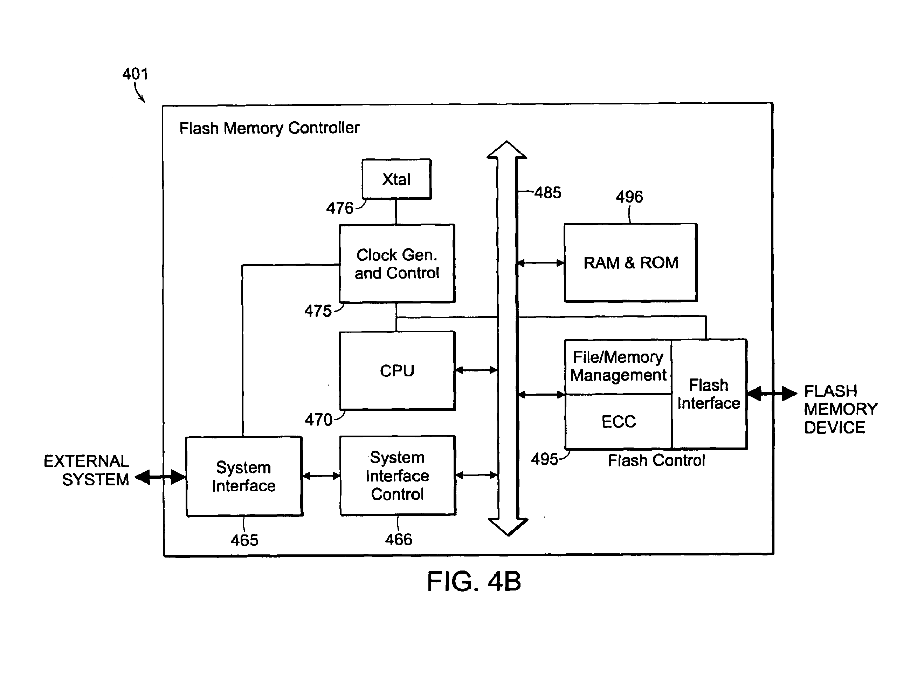

Flash memory is one type of nonvolatile memory, which is capable of maintaining stored data without a supplied electrical source or frequent refresh operations. In alternative embodiments, other types of nonvolatile memory may be utilized in place of one or more of the Flash memory devices 230a-n, or may be incorporated into the Flash devices 230a-n. Likewise, volatile memory such as static random access memory (SRAM) and dynamic random access memory (DRAM) may be incorporated into the Flash memory devices 230an. Such alternative embodiments may also require the controller 220 to operate according to the specifications of the memory, or may necessitate additional or replacement memory controllers. Operation of a Flash memory controller is described in further detail below with reference to Fig. 4.

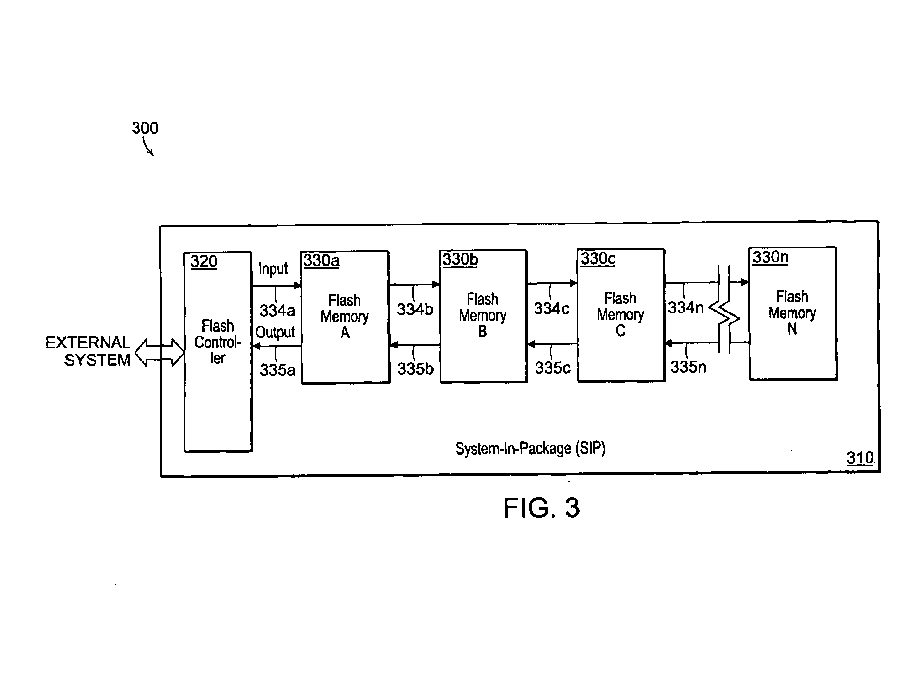

Fig. 3 is a block diagram illustrating a memory system 300 in a system-in-package (SIP) enclosure 310 with a plurality of Flash memory devices 330a-n configured in a daisy chain cascade arrangement. The memory system 300 may be compared to the system 200 of Fig. 2 insofar as the Flash controller 320 and Flash memory devices 330a-n may be configured in a similar manner as the controller 220 and devices 230a-n, described above with reference to Fig. 2. However, the controller 320 and devices 330a-n of the present system 300 communicate via signals in a bidirectional daisy chain cascade, a signal path 334, 335 comprising multiple links 334a-n, 335a-n connecting the devices at input and output ports. The signal path 334, 335 represents a flow of communication signals from the Flash controller 320 and through the Flash memory devices 330a-n in the daisy chain cascade via signal path 334, returning to the Flash controller 320 via signal path 335.

The Flash controller 320 communicates with an external system (not shown), such as a computer system, through a system interface. The system interface provides a plurality of signal paths between the Flash controller 320 and an external system, the signal paths sending and receiving memory data, commands, clock signals and other signals associated with controlling the memory system 300.

In response to communication with an external system or other instructions, the Flash controller 320 may communicate with one or more of the Flash memory devices 330a-n arranged in a bidirectional daisy chain cascade. In the bidirectional daisy chain cascade configuration depicted here, the Flash controller 320 sends command and data signals through signal path 334a to the first Flash memory device 330a ("Flash memory A") in the daisy chain cascade. Each Flash memory device 330a-n in the daisy chain cascade transfers received signals to a successive device via signal path 334, until the last device in the daisy chain cascade ("Flash memory N" 330n) receives the signals.

Each device 330a-n responds to received signals that are addressed to it, sending responsive generated signals to the Flash controller 320 via signal path 335. For example, the Flash controller may send a "read" command addressed to Flash memory device B 330b to retrieve data stored at the device. The command is passed through Flash memory A 330a (via links 334a-b) and received by Flash memory B 330b. Flash memory B responds to the command by sending the requested data to the Flash controller 320 via links 335a-b. Flash memory B also sends the command to Flash memory C 330c, which in turn sends the command further through the cascade to the last device, Flash memory N 300n.

Under some conditions, the Flash controller 320 may address more than one memory device for a particular command. Further to the above example, the command may also request data from Flash memory device C 330c. In such a case, the device would receive the command from Flash memory B 330b, and send the requested data to the Flash controller 320 by outputting the data through link 335c. As a result, the Flash controller 320 would receive requested data from both Flash memory devices B and C 330b, 330c through the signal path 335.

Thus, the Flash memory controller 320 may control the Flash memory devices 330a-n by sending control and data signals that are transferred through the devices 330a-n in a first direction through the bidirectional daisy chain cascade (i.e., signal path 334), and responsive communication is returned to the controller 320 through signals transferred in a second direction through the bidirectional daisy chain cascade (i.e., signal path 335). The memory devices 330a-n may also be configured to return the control and data signals to the Flash controller 320, where the last device in the cascade (Flash memory device 330n) sends the control and data signals through signal path 335.

The bidirectional daisy chain cascade of the memory system 300 provides each memory device 330a-n with both ingress and egress links along the signal path 334, 335 to devices in the daisy chain cascade to which it is connected. In alternative embodiments, the devices may communicate through the links in other configurations. For example, a memory device other than the last device 330n in the daisy chain cascade may be configured to transfer responsive communication to the previous device. Flash memory B 330b may receive commands and data from the previous device 330a and transmit responsive communication back to the previous device 330a for reception by the Flash controller 320, rather than (or in addition to) transmitting the communication to the subsequent device 330c. Flash memory B can be further configured to perform this operation when receiving certain types of communication, such as high-priority commands or data. Such a configuration may be implemented in one or more devices in the daisy chain cascade, and may be useful for decreasing the latency of certain operations in the memory system 300.

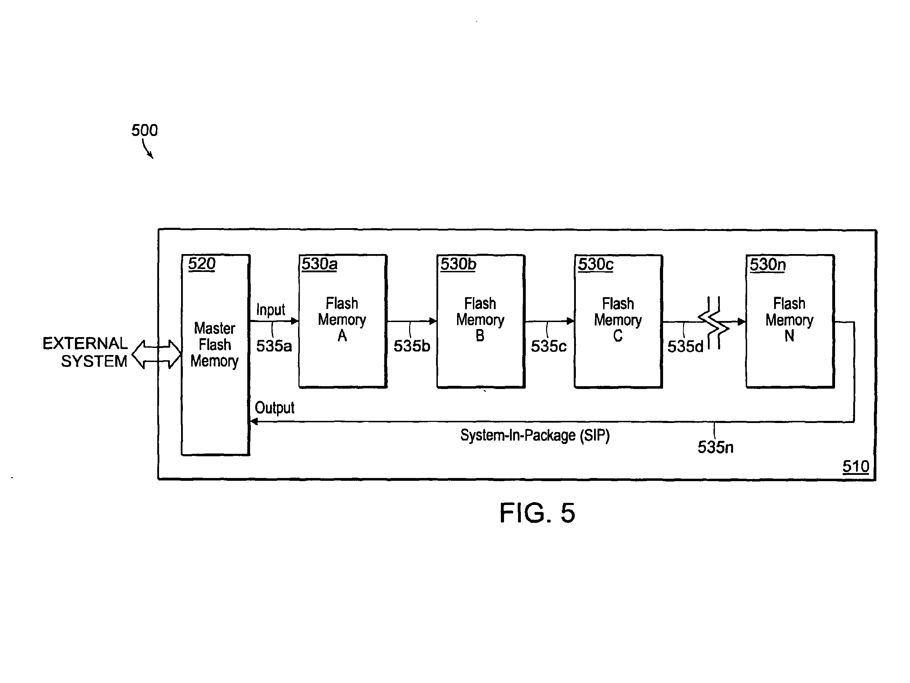

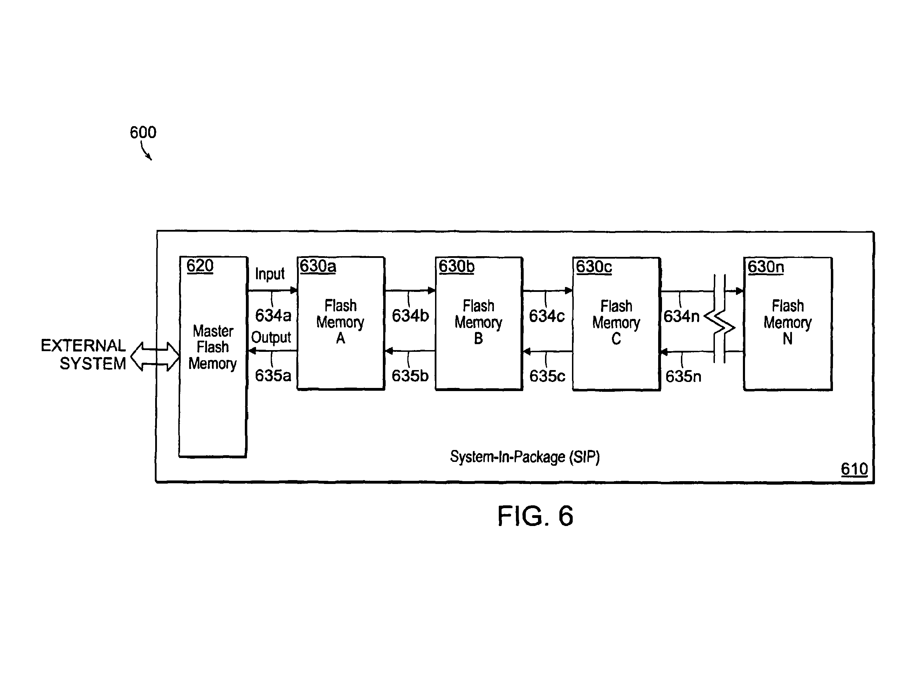

Fig. 4A is a block diagram of an exemplary Flash memory controller 400. Embodiments of the controller 400 may be implemented on an individual integrated circuit die and utilized in an SIP as the Flash memory controllers 220, 320, 820, 920 of respective memory systems 200, 300, 800, 900 with reference to Figs. 2, 3, 8 and 9, above and below. The controller 400 may also be embedded in a Flash memory chip, the controller 400 and memory operating as a master Flash memory that may be implemented as the master Flash memory 520, 620 of respective memory systems 500, 600 with reference to Figs. 5 and 6, below.

The Flash memory controller 400 may perform some or all operations specific to controlling Flash memory devices. For example, typical Flash memory is read and programmed to in individual pages comprising a predetermined number of memory bits, and erased in blocks comprising a number of pages. Commands corresponding to such operations may be stored to the Flash memory for retrieval by a device controller. NAND Flash memory is accessed by individual pages. Retrieved pages may further be copied to an external memory, such as a random access memory (RAM), where specific data within the page is retrieved. Some write and access operations may also be performed within a Flash memory device itself, thus obviating some functionality required at the Flash memory controller 400.

The Flash memory controller 400 includes a system interface 480, control logic 410 and a Flash memory interface 490. The system interface 480 is adapted for communication with an external host system, and may be configured as a NOR Flash interface or an interface utilized with other memory devices such as Double Data Rate (DDR) Dynamic Random Access Memory (DRAM), RAMBUS DRAM interface, serial ATA (SATA) interface, IEEE 1394, MMC interface, or a universal serial bus (USB). Alternatively, the system interface 480 may be located separate from the control logic 410, implemented as a separate device or internal to a system in communication with the Flash controller 400.

The control logic 410 includes buffer RAMs 420; mode, timing and data control 425; internal registers 430; and error correction code (ECC) logic 435. The control logic 410 communicates with an external system and Flash memory devices via the system interface 480 and Flash memory interface 490, respectively. The buffer RAMs 420 provide an internal buffer for ingress and egress data transactions with the system interface 480. Internal registers 430 may include address registers, command registers, configuration registers, and status registers. The mode, timing and data control 425 may be driven by a state machine receiving input from the Flash memory interface 490, ECC logic 435, internal registers 430 and buffer RAMs 420. ECC logic 435 provides error detection and correction to the mode, timing and data control 425.

The Flash memory interface 490 is a physical flash interface for communication with one or more Flash memory devices arranged in a daisy chain cascade arrangement. An exemplary Flash interface is described in U.S. Provisional Application No. 60/839,329 ("NAND Flash Memory Device"), which is hereby incorporated by reference in its entirety as though fully set forth herein. Further, the Flash memory interface 490 and control logic 410 may be configured to control NAND Flash memory devices, while providing a NOR, DRAM or other interface at the system interface 480, described above. Thus, the Flash memory controller 400 may operate as a "hybrid" controller, providing control of NAND Flash memory through communication with an external host system at a NOR or other interface.

The Flash memory controller 400, as implemented in embodiments of the present invention, may operate as a system controller, controlling the memory devices via commands and data sent through the cascade. Such commands and data are received by a device controller at each memory device (not shown), which in turn performs algorithms responsive to the commands for controlling the respective memory array.

The control logic 410 may provide a file memory management, as shown in the Flash Control 495 in Fig. 4B. The file memory management provides mapping of logical addresses to physical addresses, determining the physical addresses of the requested data. The mapping may further include algorithms that distribute and redistribute data stored at the devices to improve performance or perform wear-leveling.

In an exemplary "read" operation, the Flash memory controller 400 receives a data request at the system interface 480 from an external host system (not shown). The data request indicates a logical address to data stored on one or more of the memory devices controlled by the memory controller 400. The control logic 410 determines the corresponding physical address(es). Through the Flash memory interface 490, the controller 400 issues a "read command" through the cascade of memory devices, accompanied by the physical address of the requested data. A targeted memory device performs a "read" algorithm to retrieve the requested data, which may include loading a page to a device page buffer. The targeted memory device transmits the requested data to the Flash memory controller 400 at the Flash memory interface 490. The control logic 410 verifies the received data and corrects for errors at the error-correction code (ECC) module 435. The control logic 410 then loads the requested data to the buffer RAMs 420, which is transmitted to the external host system via the system interface 480.

A program operation is comparable to the read operation described above, where the Flash memory controller 400 receives, from an external host system, data to be stored to one or more of the memory devices. The control logic 410 determines a physical address to which to store the data, based on one or more of a data mapping, distribution and wear leveling scheme. Given the physical address, the Flash memory controller 400 transmits a "program command," accompanied by the data and determined physical address, through the cascade of memory devices. A targeted memory device loads the data to a page buffer and initiates a "program" algorithm to write the data to the physical address determined by the memory controller 400. Following this write operation, the targeted device issues a "program verify" signal to indicate whether the write was successful. The targeted memory device repeats this cycle of "program" and "program verify" until the "program verify" indicates a successful write operation.

In controlling a plurality of cascaded memory devices, as described above, the memory controller 400 employs a communication protocol that is distinct from a protocol to control a single memory device or a plurality of devices in a multi-drop arrangement. For example, the memory controller 400 in selecting a targeted memory device must issue an address corresponding to the memory device. This address (or aforementioned target device ID) may be integrated into the structure of a control command, thereby enabling a particular device in the cascade to be selected.

Fig. 4B is a block diagram depicting a second exemplary flash memory controller 401, which may be configured in one or more configurations described above with reference to Flash controller 400. Flash controller 401 may be distinguished from controller 400 in that it includes a central processing unit (CPU) 470, which may be useful in more complex tasks.

In addition to components described above with reference to Fig. 4A, the Flash memory controller 401 includes a Crystal oscillator (Xtal) 476, which provides a base clock signal which is connected to clock generator & control block. A clock generator & control block 475 provides various clock signals to the CPU 470, Flash control 495 and system interface 465. The CPU 470 communicates with other subsystems through a common bus 485. Also connected to the common bus 485 is RAM and ROM circuitry 496, in which RAM provides buffer memory and ROM stores executable codes. The Flash controller 495 includes a physical flash interface, ECC block and file & memory management block. Flash devices are accessed through the physical flash interface. Accessed data from flash devices are checked and corrected by the ECC block. The file & memory management block provides logical-to physical address translation, wear-leveling algorithm, and other functions.

Fig. 5 is a block diagram of another exemplary memory system 500 enclosed in an SIP enclosure. The system includes a number of devices enclosed in an SIP enclosure, the enclosure housing a master Flash memory device 520 and a plurality of Flash memory devices 530a-n configured in a unidirectional daisy chain cascade along a signal path 535. The signal path 535 comprises multiple links 535a-n connecting the devices. The master Flash memory device 520 transmits commands and data at link 535a to the first memory device 530n, and receives responsive communication at the link 535n from the last memory device 530n in the daisy chain cascade.

The system 500 may incorporate features described with regard to systems 200, 300 referring to Figs. 2 and 3, above. The master Flash memory 520 includes a Flash memory controller embedded with a Flash memory on a single integrated circuit die. The embedded Flash controller may incorporate features of the Flash controllers 400, 401 described above with reference to Figs. 4A-B. The master Flash device 520 communicates with an external system through a system interface, and controls the Flash memory devices 530a-n configured in a unidirectional daisy chain cascade. Furthermore, the master Flash device also controls its internal Flash memory, thereby providing additional memory for use by the external system. Thus, by utilizing a master Flash memory 520 rather than a discrete Flash memory controller, it may be possible to achieve higher memory capacity in a memory system 500 enclosed in an SIP enclosure 510.

Fig. 6 is a block diagram of an alternative Flash memory system 600 in an SIP enclosure 610, the system 600 having a master Flash memory 620 controlling a plurality of Flash memory devices 620a-n. The devices are configured in a bidirectional daisy chain cascade along a signal path 634, 635 comprising links 634a-n, 635a-n connecting the devices. The system 600 may incorporate features described above with regard to systems 200, 300, 500 of Figs. 2, 3 and 5.

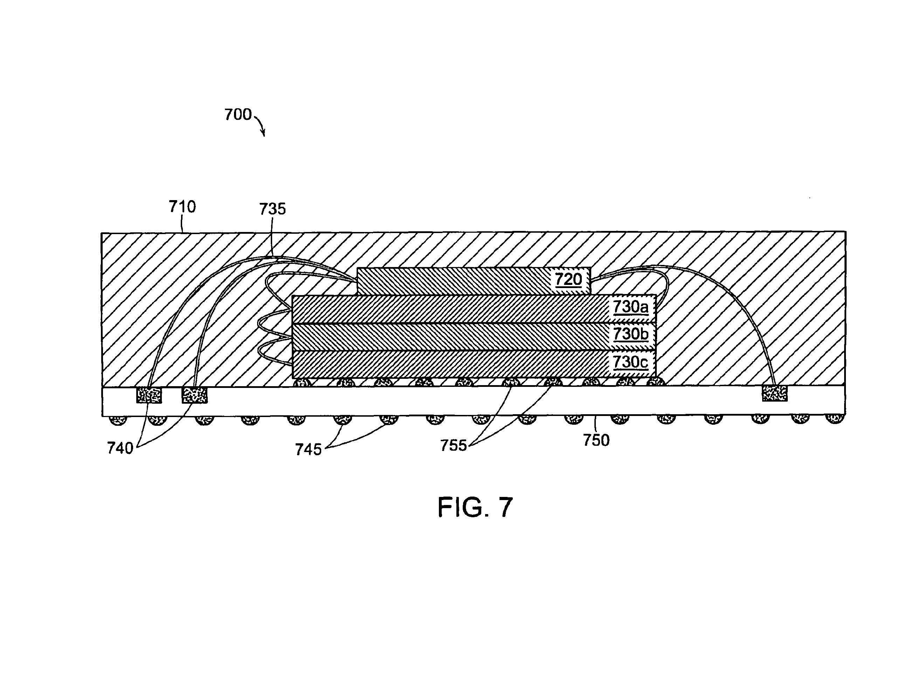

Fig. 7 is a block diagram of an exemplary memory system 700 as implemented in an SIP layout. The system comprises a number of chips, including a memory controller 720 and a plurality of memory devices 730a-c, in a vertical stack mounted on a wiring board 750 and housed within an SIP enclosure 710. The SIP enclosure 710 may comprise a sealing medium or resin that encases system components at all sides, thereby providing a rigid package in which the components are fixed. The chips 720, 730a-c are connected by wires 735 that are also encased in the enclosure 710. Alternatively, the chips 720, 730a-c may be placed horizontally alongside one another inside the enclosure 710 according to design constraints, or may be connected using solder bumps to join them together in a "flip-chip" technology.

The memory device 730c is connected to the wiring board 750 by multiple terminals (e.g., terminals 755), through which the device 730c may send and receive signals. The terminals 755 are connected to external terminals (e.g., terminals 745) on the opposite surface of the wiring board 750, enabling communication with an external system. Similarly, the memory controller 720 may communicate with an external system through signal paths comprising wires 735 connected to terminals 740, which in turn connect to one or more external terminals 745.

The block diagram of Fig. 7 provides an illustrative example of a memory system 700 implemented in an SIP enclosure 710. Components and connections of the system 700 as described above can be configured differently according to the design requirements of a particular embodiment. For example, the memory systems 200, 300, 500, 600, 800, 900 of Figs. 2, 3, 5, 6, 8 and 9 may be implemented as a memory system comparable to the system 700 of Fig. 7. Such a memory system therefore provides an SIP enclosure housing a memory controller and a plurality of memory devices in a daisy chain cascade arrangement, the controller controlling the memory devices through the cascade.

A system-in-package (SIP) is one example of a single form-factor embodiment in which the memory systems 200, 300, 500, 600, 800, 900 may be implemented. The memory systems may also be implemented in other suitable devices or common support assembly in which the component memory controller and memory devices are configured for communication with an external system. For example, a memory system may be realized as a circuit board, such as a memory card, wherein the controller and memory devices comprise chips that are coupled to the board and communicate via signal paths at the circuit board.

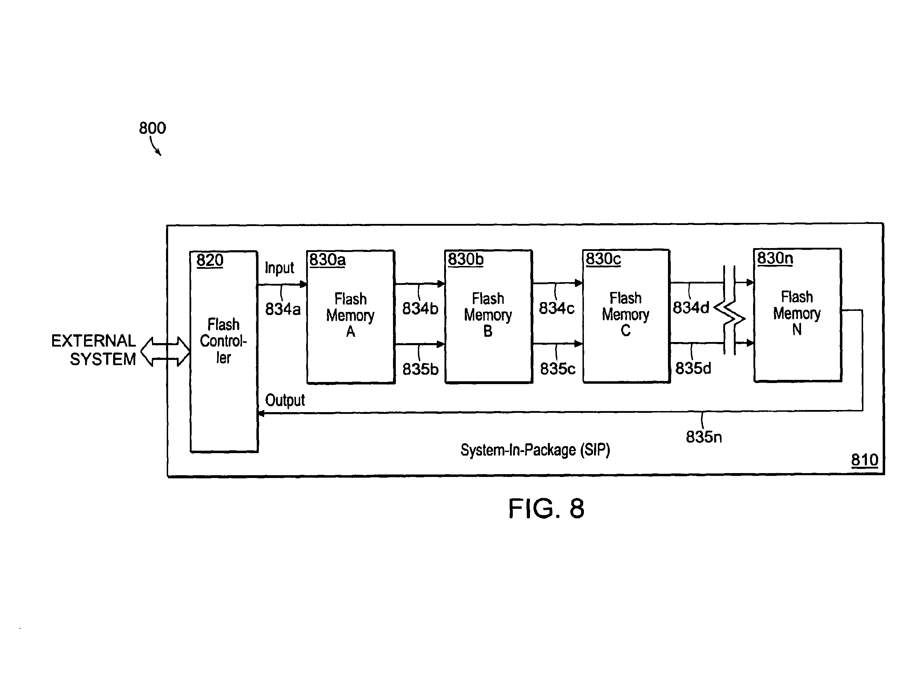

FIG. 8 is a block diagram of a memory system 800 in an SIP enclosure 810 with a plurality of memory devices 830a-n configured in a unidirectional daisy chain cascade comprising multiple connections. The devices 830a-n are controlled by the flash controller 820 via commands transmitted through the signal path 834, 835 comprising links between each memory device 830a-n. This configuration is comparable to that of the system 200 of Fig. 2, except that each of the devices 830a-n are connected by two unidirectional paths rather than one. The memory system may also incorporate features described above with reference to the systems 200, 300 of Figs. 2 and 3, including the Flash controller 820 addressing multiple Flash memory devices 830a-n. In this embodiment, commands and data sent by the Flash controller 820 through link 834a are transmitted through the signal path 834 by links 834b-d. Data responsive to the commands are transmitted through the signal path 835 comprising link 835b-n, and are received by the flash controller 820. Commands and data sent by the Flash controller may also be returned to the Flash controller via link 835n. Thus, the signal path 835 comprising the unidirectional daisy chain cascade is divided into a first path 834a-d (upper) that is dedicated to carry commands and data from the Flash Controller 820, and a second path 835b-n (lower) that is dedicated to carry responsive data generated by each of the memory devices 830a-n.

In alternative embodiments, the memory system 800 may be adapted to implement a master Flash memory as described above. In such a case, the Flash Controller 920 may be replaced with a master Flash memory, controlling the Flash memory devices 930a-n as described with reference to Fig. 5.

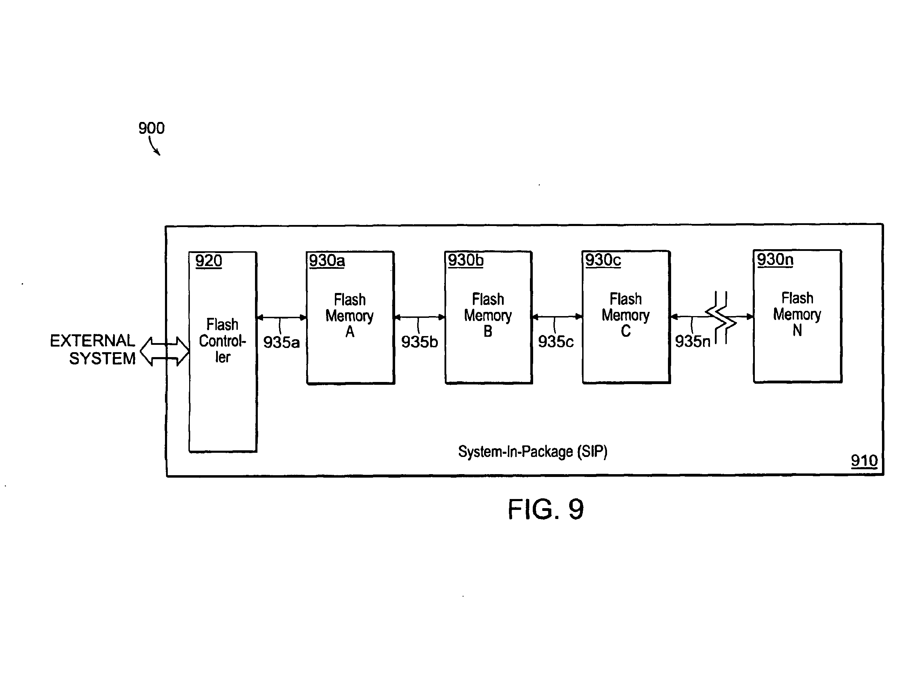

FIG. 9 is a block diagram of a memory system 900 in an SIP enclosure 910 with a plurality of memory devices 930a-n configured in a bidirectional daisy chain cascade sharing common input/output ports. The devices 930a-n are controlled by the flash controller 820 via commands transmitted through the signal path 935 comprising links between each memory device 930a-n. This configuration is comparable to that of the system 300 of Fig. 3, except that each of the links 935b-n is a single bidirectional link rather than rather than two unidirectional links. The links 935b-n may connect to common input/output ports at each device 930a-n, thereby enabling bidirectional communication through each link 935b-n. Commands and data sent by the Flash Controller 920 are transmitted through the signal path 935a-n to each memory device 930a-n. Data responsive to the commands are also transmitted through the signal path 935b-n, and are transmitted to the Flash Controller at link 935a. Thus, the bidirectional daisy chain cascade is enabled on a signal path 935 comprising a number of links 935a-n sharing common input/output ports.

In alternative embodiments, the memory system 900 may be adapted to implement a master Flash memory as described above. In such a case, the Flash Controller 920 may be replaced with a master Flash memory, controlling the Flash memory devices 930a-n as described with reference to Fig. 6.

While this invention has been particularly shown and described with references to example embodiments thereof, it will be understood by those skilled in the art that various changes in form and details may be made therein without departing from the scope of the invention encompassed by the appended claims.

## Claims

1. A controller comprising:
an interface to communicate with an external system; and
a processor configured to:
receive communications from the external system; and
send a command associated with the communications to a plurality of memory devices in a daisy chain cascade arrangement.

2. The controller of claim 1, further comprising memory containing a mapping of logical addresses to physical address in the plurality of memory devices.

3. The controller of any one of claims 1 to 2, wherein the processor is further configured to provide wear leveling among the plurality of memory devices.

4. The controller of any one of claims 1 to 3, further comprising nonvolatile memory connected to the plurality of memory devices in the daisy chain cascade arrangement.

5. The controller of any one of claims 1 to 4, wherein the processor is further configured to send, with the command, an address associated with the one of the plurality of memory devices.

6. The controller of any one of claims 1 to 5, wherein the processor is further configured to receive data from one of the plurality of nonvolatile memory devices responsive to the command.

7. The controller of any one of claims 1 to 6, wherein the interface is one of a NOR interface, MMC interface, SD interface, ATA interface, USB interface, and IEEE 1394 interface.

8. A method for controlling a plurality of memory devices, comprising:
communicating with an external system;
receiving communications from the external system; and
sending a command associated with the communications to a plurality of memory devices in a daisy chain cascade arrangement.

9. The method of claim 8, further comprising mapping logical addresses to physical address in the plurality of memory devices.

10. The controller of any one of claims 1 to 2, further providing wear leveling among the plurality of memory devices.

11. The controller of any one of claims 1 to 4, further providing sending, with the command, an address associated with the one of the plurality of memory devices.

12. The controller of any one of claims 1 to 5, further comprising receiving data from one of the plurality of nonvolatile memory devices responsive to the command.

13. A system comprising a controller and a plurality of memory devices, the controller being defined as any one of claims 1 to 7 and 10 to 12.

14. The system of claim 13, wherein the controller includes a processor configured to communicate with the plurality of memory devices.

15. The system of any one of claims 13 to 14, wherein the plurality of memory devices is configured in any one of unidirectional and bidirectional daisy chain cascades.
